# EUROPÄISCHE PATENTANMELDUNG

(11) **EP 1 884 986 A2**
(43) Veröffentlichungstag der Anmeldung: **06.02.2008**
(21) Anmeldenummer: 07013633.8
(22) Anmeldetag: 12.07.2007
(51) Int. Cl.: H01L 21/28, H01L 21/336, H01L 21/8246, H01L 27/115, H01L 29/792, H01L 29/423

(54) **Wiederprogrammierbare nichtflüchtige Speicherzelle und deren Herstellungsverfahren**

(30) Priorität: 02.08.2006 DE 102006036098
(71) Anmelder: Qimonda AG, 81739 München (DE)
(72) Erfinder: Ufert, Klaus-Dieter, 85716 Unterschliessheim (DE); Willer, Josef, 85521 Riemerling (DE)
(74) Vertreter: Patentanwaltskanzlei WILHELM & BECK

(57) **Zusammenfassung**

Die vorliegende Erfindung betrifft eine wiederprogrammierbare nichtflüchtige Speicherzelle, welche einen Auswahltransistor (10) mit einer Isolationsschicht (120), einem ersten Anschluss (110) auf der Isolationsschicht (120), einem zweiten Anschluss (130) unterhalb der Isolationsschicht (120) und in einem Bereich unterhalb des ersten Anschlusses (110), einem von dem zweiten Anschluss (130) getrennten dritten Anschluss (141) unterhalb der Isolationsschicht (120) und in einem Bereich unterhalb des ersten Anschlusses (110) sowie ein Speicherelement (20) mit einem vierten Anschluss (141), einem fünften Anschluss (180) und einer wiederprogrammierbaren Dielektrizitätsschicht (170) aufweist, wobei der vierte Anschluss (141) und der fünfte Anschluss (180) des Speicherelements (20) durch die wiederprogrammierbare Dielektrizitätsschicht (170) voneinander getrennt sind und der dritte Anschluss (141) des Auswahltransistors (10) mit dem vierten Anschluss (141) des Speicherelements (20) verbunden ist. Die Erfindung zeichnet sich dadurch aus, dass die wiederprogrammierbare Dielektrizitätsschicht (170) des Speicherelements (20) im Wesentlichen orthogonal zu der Isolationsschicht (120) des Auswahltransistors (10) angeordnet ist. Die Erfindung betrifft ferner ein Verfahren zur Herstellung einer derartigen Speicherzelle (1) sowie ein Speicherzellenfeld mit einer Anzahl von solchen Speicherzellen (1).

## Beschreibung

Die vorliegende Erfindung betrifft eine wiederprogrammierbare nichtflüchtige Speicherzelle, deren Speichereigenschaft auf dem Hervorrufen eines dielektrischen Durchbruchs einer Dielektrizitätsschicht beruht. Die Erfindung betrifft ferner ein Verfahren zum Herstellen einer derartigen Speicherzelle sowie ein Speicherzellenfeld mit einer Anzahl von solchen Speicherzellen.

In unterschiedlichen datenverarbeitenden Systemen und Vorrichtungen werden so genannte nichtflüchtige Speicher eingesetzt. Diese Speicher weisen Speicherzellen auf, in denen gespeicherte Informationen auch ohne Energiezufuhr von außen zuverlässig erhalten bleiben. Dadurch tritt im Gegensatz zu flüchtigen Datenspeichern kein Verlieren des Speicherinhalts unmittelbar nach Abschalten der Versorgungsspannung des Speichers auf.

Ein bekannter Typ eines nichtflüchtigen Speichers stellt der so genannte PROM-Festspeicher (Programmable Read Only Memory) dar, dessen beispielsweise als Schmelzsicherungen (Fuses) ausgeführte Speicherzellen üblicherweise lediglich einmal programmiert werden können. Des Weiteren sind wiederprogrammierbare nichtflüchtige Speicher wie beispielsweise der EPROM-Speicher (Erasable Programmable Read Only Memory) und der EEPROM-Speicher (Electrically Erasable Programmable Read Only Memory) bekannt. Bei diesen Speichertypen bestehen die Speicherzellen jeweils aus einem MOSFET-Transistor (Metal Oxide Semiconductor Field Effect Transistor), welcher eine als "Floating Gate" bezeichnete isolierte Hilfselektrode aufweist.

Ein Programmiervorgang des Speichers beruht hierbei auf dem Aufbringen einer elektrischen Ladung auf die Hilfselektroden der Transistoren, wodurch die Ansteuerspannung der zugehörigen Transistoren und damit deren Speicherinhalt vorgegeben wird. Beim Lesen des Speichers wird die Ansteuerspannung der Transistoren jeweils abgetastet.

Das Löschen eines Speicherinhalts erfolgt durch Entladen von Hilfselektroden der Transistoren. Zu diesem Zweck wird bei einem EPROM-Speicher UV-Licht eingesetzt. Bei einem EEPROM-Speicher wird der Löschvorgang hingegen auf elektrische Art und Weise durchgeführt. Anschließend können die Speicher durch erneutes Aufladen von Hilfselektroden der Transistoren wiederprogrammiert werden.

Darüber hinaus sind wiederprogrammierbare nichtflüchtige Speicher bekannt, die auf dem Ausnutzen weiterer elektrischer Eigenschaften und Phänomene basieren. Die US 6,956,258 B2 offenbart einen Speicher, bei dem zum Festlegen einer binären Information ein dielektrischer Durchbruch einer Dielektrizitätsschicht hervorgerufen wird. Bei diesem Speicher sind die auf einem Substrat angeordneten Speicherzellen jeweils als Serienschaltung eines MOS-Auswahltransistors und eines als MOS-Halbtransistor bezeichneten Speicherelements über einen in einem p-dotierten Bereich des Substrats eindiffundierten gemeinsamen n+ -Kontakt ausgeführt. Der Auswahltransistor und das Speicherelement einer Speicherzelle sind dabei im Wesentlichen in einer Ebene lateral nebeneinander angeordnet.

Das Speicherelement weist hierbei die für die Programmierung vorgesehene Dielektrizitätsschicht auf, welche als Oxidschicht ausgebildet ist. Zum Programmieren einer Speicherzelle kann mithilfe des entsprechenden Auswahltransistors eine hinreichend große Potentialdifferenz über der Dielektrizitätsschicht des betreffenden Speicherelements erzeugt und damit ein dielektrischer Durchbruch der Dielektrizitätsschicht hervorgerufen werden, welcher das Niveau des Leckstroms durch die Speicherzelle vorgibt. Bei einem Lesevorgang wird das Leckstromniveau der einzelnen Speicherzellen abgetastet.

Dieser Vorgang des Erzeugens einer Potentialdifferenz über der Dielektrizitätsschicht des Speicherelements einer Speicherzelle kann mehrfach zu dem Zweck einer Wiederprogrammierung der betreffenden Speicherzelle wiederholt werden, um die Stärke bzw. den Grad des Durchbruchs der Dielektrizitätsschicht schrittweise zu erhöhen und damit den Widerstand des Speicherelements der Speicherzelle zu erniedrigen. In entsprechender Weise erhöht sich mit dem Grad des dielektrischen Durchbruchs das Leckstromniveau der jeweiligen Speicherzelle, welches wiederum bei einem Lesen der Speicherzelle abgetastet wird.

Ein wesentlicher Gesichtspunkt in der CMOS-Speichertechnologie (Complementary Metal Oxide Semiconductor) stellt der Platzbedarf einer einzelnen Speicherzelle eines Speichers dar. Bei dem vorstehend beschriebenen Speicher nimmt eine Speicherzelle aufgrund der planaren Anordnung des Auswahltransistors und des Speicherelements, bei denen die Dielektrizitätsschicht des Speicherelements und eine Gateoxidschicht des Auswahltransistors in einer Ebene auf der Oberfläche des Substrats angeordnet sind, eine relativ große Fläche ein. In entsprechender Weise ergibt sich ein relativ großer lateraler Platzbedarf eines aus den Speicherzellen aufgebauten Speicherzellenfeldes, wodurch der Speicher den Anforderungen der Halbleiterindustrie an eine hohe Integrationsdichte nur ungenügend gerecht wird.

Die Aufgabe der vorliegenden Erfindung besteht darin, eine auf dem Hervorrufen eines dielektrischen Durchbruchs einer Dielektrizitätsschicht beruhende wiederprogrammierbare nichtflüchtige Speicherzelle mit einem geringeren lateralen Platzbedarf, ein Verfahren zum Herstellen einer derartigen Speicherzelle sowie ein Speicherzellenfeld mit einer Anzahl von solchen Speicherzellen anzugeben.

Diese Aufgabe wird durch eine wiederprogrammierbare nichtflüchtige Speicherzelle gemäß Anspruch 1, ein Verfahren zum Herstellen einer derartigen Speicherzelle gemäß Anspruch 11 und ein Speicherzellenfeld mit einer Anzahl von solchen Speicherzellen gemäß Anspruch 20 gelöst. Weitere vorteilhafte Ausführungsformen der Erfindung sind in den abhängigen Ansprüchen angegeben.

Erfindungsgemäß wird eine wiederprogrammierbare nichtflüchtige Speicherzelle vorgeschlagen. Die Speicherzelle weist einen Auswahltransistor mit einer Isolationsschicht, einem ersten Anschluss auf der Isolationsschicht, einem zweiten Anschluss unterhalb der Isolationsschicht und in einem Bereich unterhalb des ersten Anschlusses sowie einem von dem zweiten Anschluss getrennten dritten Anschluss unterhalb der Isolationsschicht und in einem Bereich unterhalb des ersten Anschlusses auf. Des Weiteren weist die Speicherzelle ein Speicherelement mit einem vierten Anschluss, einem fünften Anschluss und einer wiederprogrammierbaren Dielektrizitätsschicht auf, wobei der vierte Anschluss und der fünfte Anschluss des Speicherelements durch die wiederprogrammierbare Dielektrizitätsschicht voneinander getrennt sind und wobei der dritte Anschluss des Auswahltransistors mit dem vierten Anschluss des Speicherelements elektrisch verbunden ist. Das Programmieren der Speicherzelle basiert auf dem Hervorrufen eines Durchbruchs der Dielektrizitätsschicht des Speicherelements durch Erzeugen einer Potentialdifferenz über der Dielektrizitätsschicht mithilfe des vierten und fünften Anschlusses des Speicherelements. Für eine Wiederprogrammierung der Speicherzelle kann der Grad des dielektrischen Durchbruchs erhöht werden. Die erfindungsgemäße Speicherzelle zeichnet sich dadurch aus, dass die wiederprogrammierbare Dielektrizitätsschicht des Speicherelements im Wesentlichen orthogonal zu der Isolationsschicht des Auswahltransistors angeordnet ist.

Aufgrund der Tatsache, dass die Dielektrizitätsschicht des Speicherelements und die an einer Oberfläche eines Substrats ausgebildete Isolationsschicht des Auswahltransistors erfindungsgemäß im Wesentlichen rechtwinklig zueinander orientiert sind, können der Auswahltransistor und das Speicherelement im Gegensatz zu der oben beschriebenen, herkömmlichen planaren Anordnung in einem geringeren Abstand zueinander angeordnet werden. Infolgedessen weist die auf einem Substrat ausgebildete erfindungsgemäße Speicherzelle einen geringeren lateralen Platzbedarf auf der Substratoberfläche auf.

Gemäß einer bevorzugten Ausführungsform sind der dritte Anschluss des Auswahltransistors und der vierte Anschluss des Speicherelements als gemeinsamer Anschluss ausgebildet. Auf diese Weise wird eine besonders platzsparende laterale Ausdehnung der Speicherzelle ermöglicht.

Gemäß einer weiteren bevorzugten Ausführungsform weist der vierte Anschluss des Speicherelements eine zu der Isolationsschicht des Auswahltransistors im Wesentlichen orthogonal verlaufende Anschlussfläche auf. An dieser Anschlussfläche des vierten Anschlusses ist die wiederprogrammierbare Dielektrizitätsschicht des Speicherelements ausgebildet.

In einer weiteren bevorzugten Ausführungsform wird die Anschlussfläche des vierten Anschlusses des Speicherelements durch eine zu der Isolationsschicht des Auswahltransistors im Wesentlichen orthogonal verlaufende Seitenwand eines Grabens vorgegeben. Diese Ausführungsform ermöglicht in vorteilhafter Weise eine einfache Herstellung der im Wesentlichen rechtwinklig zu der Isolationsschicht des Auswahltransistors orientierten Anschlussfläche des vierten Anschlusses des Speicherelements durch beispielsweise Ätzen des Grabens in das Substrat in einem Bereich des späteren vierten Anschlusses.

Gemäß einer weiteren bevorzugten Ausführungsform weist die wiederprogrammierbare Dielektrizitätsschicht des Speicherelements eine Dicke in einem Bereich von 2nm bis 3nm auf. Durch diese Ausgestaltung wird ein zuverlässiger Betrieb der Speicherzelle ermöglicht, da bei einer Programmierung bzw. Wiederprogrammierung der Speicherzelle lediglich die Dielektrizitätsschicht des Speicherelements durchbrochen wird. Ein die Speicherzelle beschädigendes Durchbrechen der Isolationsschicht des Auswahltransistors, welche vorzugsweise eine größere Dicke in einem Bereich von beispielsweise größer 5nm aufweist, wird hingegen vermieden.

Erfindungsgemäß wird des Weiteren ein Verfahren zum Herstellen einer wiederprogrammierbaren nichtflüchtigen Speicherzelle vorgeschlagen. Das Verfahren umfasst ein Bereitstellen eines Substrats und ein Ausbilden einer Ausgangsstruktur, welche eine Isolationsschicht an einer Oberfläche des Substrats, einen ersten Anschluss auf der Isolationsschicht, einen zweiten Anschluss unterhalb der Isolationsschicht und in einem Bereich unterhalb des ersten Anschlusses, einen von dem zweiten Anschluss getrennten dritten Anschluss unterhalb der Isolationsschicht und in einem Bereich unterhalb des ersten Anschlusses sowie einen von dem zweiten Anschluss getrennten Anschlussbereich für einen vierten Anschluss in einem Bereich unterhalb des ersten Anschlusses aufweist, wobei der Anschlussbereich für den vierten Anschluss mit dem dritten Anschluss verbunden ist. Das Verfahren umfasst weiter ein Ausbilden einer zu der Isolationsschicht im Wesentlichen orthogonal verlaufenden Anschlussfläche an dem Anschlussbereich, um den vierten Anschluss bereitzustellen, ein Ausbilden einer Dielektrizitätsschicht an der zu der Isolationsschicht im Wesentlichen orthogonal verlaufenden Anschlussfläche des vierten Anschlusses und ein Ausbilden eines durch die Dielektrizitätsschicht von dem vierten Anschluss getrennten fünften Anschlusses an der Dielektrizitätsschicht.

In entsprechender Weise weist eine nach dem erfindungsgemäßen Verfahren hergestellte Speicherzelle aufgrund der im Wesentlichen orthogonalen Ausrichtung der für eine (Wieder-) Programmierung der Speicherzelle vorgesehenen Dielektrizitätsschicht zu der Isolationsschicht einen geringen lateralen Platzbedarf auf der Substratoberfläche auf.

Gemäß einer bevorzugten Ausführungsform umfasst das Ausbilden der Anschlussfläche für den vierten Anschluss ein Ausbilden eines Grabens in dem Substrat im Bereich des Anschlussbereichs mit einer zu der Isolationsschicht im Wesentlichen orthogonal verlaufenden Seitenwand. Diese Ausführungsform begünstigt eine einfache Herstellung der im Wesentlichen rechtwinklig zu der Isolationsschicht orientierten Anschlussfläche für den vierten Anschluss.

Gemäß einer weiteren bevorzugten Ausführungsform übersteigt eine Tiefe des Grabens eine maximale Tiefe des Anschlussbereichs. Auf diese Weise kann bei der Herstellung von zwei nebeneinander angeordneten Speicherzellen in vorteilhafter Weise ein für die beiden Speicherzellen vorgesehener gemeinsamer Anschlussbereich in zwei durch den Graben voneinander getrennte, den jeweiligen Speicherzellen zugehörige vierte Anschlüsse aufgeteilt werden, welche jeweils im Wesentlichen orthogonal zu der Isolationsschicht verlaufende Anschlussflächen aufweisen.

In einer weiteren bevorzugten Ausführungsform umfasst das Verfahren nach dem Ausbilden des Grabens ein Ausbilden einer Oxidschicht in dem Graben, wobei die Oxidschicht den Graben bis zu einem Niveau oberhalb einer maximalen Tiefe des vierten Anschlusses füllt. Die Dielektrizitätsschicht wird oberhalb der Oxidschicht an der zu der Isolationsschicht im Wesentlichen orthogonal verlaufenden Anschlussfläche des vierten Anschlusses ausgebildet. Auf diese Weise wird ein zuverlässiger Betrieb der späteren Speicherzelle ermöglicht.

Vorzugsweise umfasst das Ausbilden der Oxidschicht in dem Graben ein Ausbilden einer Zwischenoxidschicht an Seitenwänden und an einem Boden des Grabens und ein Füllen des Grabens mit einem Oxidmaterial für die Oxidschicht. Nachfolgend werden das Oxidmaterial und die Zwischenoxidschicht bis zu dem Niveau oberhalb der maximalen Tiefe des vierten Anschlusses entfernt, um die Oxidschicht in dem Graben auszubilden.

Gemäß einer weiteren bevorzugten Ausführungsform wird die Dielektrizitätsschicht als Oxidschicht an der zu der Isolationsschicht im Wesentlichen orthogonal verlaufenden Anschlussfläche des vierten Anschlusses ausgebildet. Auch diese Ausführungsform begünstigt das einfache Herstellen der wiederprogrammierbaren Dielektrizitätsschicht der Speicherzelle.

Erfindungsgemäß wird ferner ein Speicherzellenfeld mit einer Anzahl von Wortleitungen, einer Anzahl von Bitleitungen und einer Anzahl von in entsprechenden Schnittpunkten der Wortleitungen und Bitleitungen angeordneten wiederprogrammierbaren nichtflüchtigen Speicherzellen gemäß einer Ausführungsform der Erfindung vorgeschlagen. Eine Wortleitung ist hierbei mit einem ersten Anschluss eines Auswahltransistors einer Speicherzelle und eine Bitleitung mit einem fünften Anschluss eines Speicherelements einer Speicherzelle verbunden.

Das erfindungsgemäße Speicherzellenfeld weist in entsprechender Weise aufgrund der im Wesentlichen orthogonalen Ausrichtung zwischen den wiederprogrammierbaren Dielektrizitätsschichten und den Isolationsschichten der einzelnen Speicherzellen eine platzsparende laterale Ausdehnung auf der Oberfläche eines Substrats auf. Infolgedessen kann ein das Speicherzellenfeld umfassender Speicher bzw. Speicherbaustein erfindungsgemäß mit einer hohen Integrationsdichte verwirklicht werden.

Gemäß einer bevorzugten Ausführungsform wird ein geringer lateraler Platzbedarf des Speicherzellenfelds insbesondere dadurch erzielt, dass jeweils zwei nebeneinander angeordnete Speicherzellen einen gemeinsamen fünften Anschluss aufweisen.

Eine platzsparende laterale Geometrie des Speicherzellenfelds wird gemäß einer weiteren bevorzugten Ausführungsform ferner dadurch erzielt, dass jeweils zwei nebeneinander angeordnete Speicherzellen einen gemeinsamen zweiten Anschluss aufweisen.

Die Erfindung wird im Folgenden anhand der Figuren näher erläutert. Es zeigen:
Figur 1 eine schematische Draufsicht auf ein Substrat nach der Herstellung von Isolationsstreifen und Wortleitungen für ein Speicherzellenfeld mit Speicherzellen gemäß einer bevorzugten Ausführungsform der Erfindung;
Figur 2 eine schematische seitliche Schnittdarstellung des Substrats entlang Schnittlinie A-A von Figur 1;
Figuren 3 bis 8 schematische seitliche Schnittdarstellungen des Substrats entlang Schnittlinie C-C von Figur 1 zur Erläuterung weiterer Verfahrensschritte bei der Herstellung der erfindungsgemäßen Speicherzellen;
Figur 9 eine Figuren 3 bis 8 entsprechende schematische seitliche Schnittdarstellung des Substrats mit den fertig gestellten erfindungsgemäßen Speicherzellen des Speicherzellenfelds;
Figur 10 eine schematische Draufsicht auf das Substrat mit dem fertig gestellten Speicherzellenfeld;
Figur 11 eine schematische seitliche Schnittdarstellung des Substrats entlang Schnittlinie B-B von Figur 10; und
Figur 12 eine schematische seitliche Schnittdarstellung des Substrats entlang Schnittlinie A-A von Figur 10.

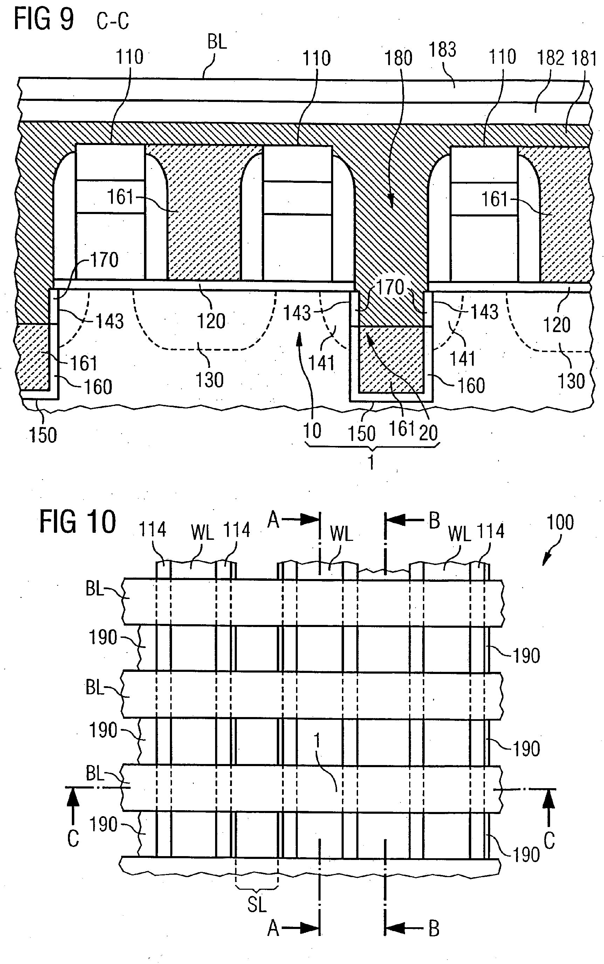

Die folgenden Figuren veranschaulichen in unterschiedlichen Ansichten die Herstellung eines Speicherzellenfelds für einen Speicher bzw. Speicherbaustein mit Speicherzellen 1 gemäß einer bevorzugten Ausführungsform der Erfindung. Eine auf diese Weise auf einem Halbleitersubstrat 100 hergestellte Speicherzelle 1 umfasst einen Auswahltransistor 10 und ein Speicherelement 20 mit einer wiederprogrammierbaren Dielektrizitätsschicht 170 (vgl. Figur 9), bei der zur Programmierung bzw. Wiederprogrammierung ein dielektrischer Durchbruch erzeugt bzw. der Grad eines dielektrischen Durchbruchs schrittweise erhöht werden kann. Die Stärke des dielektrischen Durchbruchs gibt dabei den Widerstand und damit das Niveau eines Leckstroms der Speicherzelle 1 vor, welches zum Auslesen der Speicherzelle 1 abgetastet wird.

Die Erfindung zeichnet sich durch eine orthogonale bzw. im Wesentlichen orthogonale Ausrichtung zwischen der wiederprogrammierbaren Dielektrizitätsschicht 170 des Speicherelements 20 und einer an einer Oberfläche des Substrats 100 ausgebildeten Gateoxidschicht 120 des Auswahltransistors 10 aus. Die Dielektrizitätsschicht 170 des Speicherelements 20 und die Gateoxidschicht 120 des Auswahltransistors 10 können dabei auch einen Winkel einschließen, welcher herstellungsbedingt um einen Winkel in einem Bereich von beispielsweise maximal 20° von einem rechten Winkel abweicht. Durch die erfindungsgemäße Ausgestaltung wird ein kleiner Abstand zwischen dem Auswahltransistor 10 und dem Speicherelement 20 ermöglicht, wodurch die erfindungsgemäße Speicherzelle 1 einen geringen lateralen Platzbedarf auf der Oberfläche des Substrats 100 aufweist. Im Folgenden wird zunächst auf das Herstellungsverfahren eingegangen, welches in vorteilhafter Weise insbesondere mithilfe von Standard-CMOS-Prozessschritten durchgeführt werden kann.

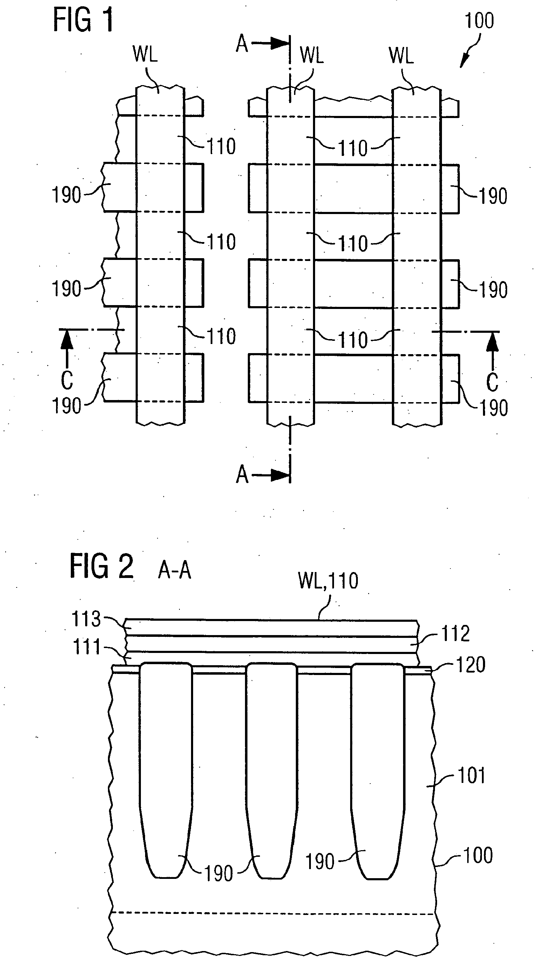

Zu Beginn des Herstellungsverfahrens werden in einem Substrat 100, welches einen sich von der Oberfläche erstreckenden beispielsweise p-dotierten Bereich 101 aufweist, Isolationsstreifen 190 ausgebildet (vgl. die schematische Draufsicht von Figur 1 sowie die schematische seitliche Schnittdarstellung der Figur 2 entlang Schnittlinie A-A von Figur 1). Die Isolationsstreifen 190, welche auch als STI-Streifen (Shallow Trench Isolation) bezeichnet werden und beispielsweise ein Oxidmaterial aufweisen, definieren die voneinander isolierten aktiven Bereiche für die späteren Speicherzellen 1.

Nachfolgend wird auf dem Substrat 100 eine Oxidschicht 120 ausgebildet, welche als Gateoxidschicht 120 für Auswahltransistoren 10 von späteren Speicherzellen 1 dient. Die Oxidschicht 120 ist dabei, wie anhand der seitlichen Schnittdarstellung von Figur 2 ersichtlich wird, an der Oberfläche des Substrats 100 zwischen den Isolationsstreifen 190 angeordnet und weist beispielsweise eine Dicke in einem Bereich größer 5nm auf.

Im Anschluss daran werden Wortleitungen WL auf der Oberfläche des Substrats 100 ausgebildet, welche gleichzeitig in den aktiven Bereichen als Gates 110 für Auswahltransistoren 10 der Speicherzellen 1 fungieren. Zu diesem Zweck werden vorzugsweise eine undotierte oder eine n+ -dotierte Polysiliziumschicht 111, eine beispielsweise WSi aufweisende Metallschicht 112 und wenigstens eine beispielsweise ein Nitrid aufweisende Hartmaskenschicht 113 großflächig auf die Oberfläche des Substrats 100 aufgebracht. Dieser Schichtenstapel wird nachfolgend mithilfe eines Lithographieverfahrens und eines oder mehrerer Ätzverfahren wie beispielsweise dem reaktiven Ionenätzen zur Ausbildung der Wortleitungen WL bzw. Gates 110 strukturiert. Die auf diese Weise hergestellten Wortleitungen WL bzw. Gates 110 sind in der schematischen Draufsicht von Figur 1 sowie in der schematischen seitlichen Schnittdarstellung der Figur 2 abgebildet.

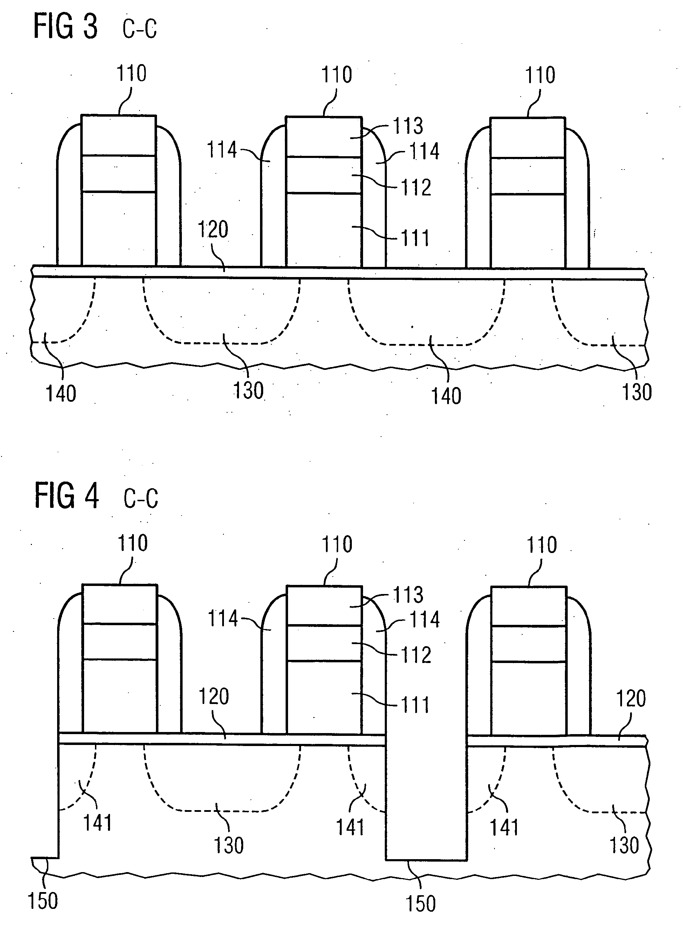

Die nachfolgenden Figuren 3 bis 9 zeigen weitere Verfahrensschritte bei der Herstellung von erfindungsgemäßen Speicherzellen 1, jeweils in einer schematischen seitlichen Schnittdarstellung entlang Schnittlinie C-C von Figur 1 und Figur 10. Zunächst werden, wie anhand von Figur 3 ersichtlich wird, seitlich an die Wortleitungen WL bzw. Gates 110 angrenzende Liner oder Spacer 114 ausgebildet. Nachfolgend werden im Rahmen eines Dotierungsverfahrens mithilfe entsprechender Implantierungsmaterialien n+ -dotierte Bereiche 130, 140 selbstjustierend unterhalb der Oxidschicht 120 zwischen den Gates 110 bzw. in einem Bereich unterhalb der Gates 110 hergestellt. Das Dotierungsverfahren kann dabei einen Annealverfahrensschritt umfassen. Aus den n+ -dotierten Bereichen 130, 140 gehen Source-/Drainanschlüsse für Auswahltransistoren 10 und Anschlüsse für Speicherelemente 20 von späteren Speicherzellen 1 hervor. Ein Bereich 130, welcher zwischen den in der Aufsicht voneinander getrennten Isolationsstreifen 190 angeordnet ist, ist des Weiteren mit einer durch Diffusionsvorgänge gebildeten vergrabenen Source-Leitung SL verbunden (vgl. Figuren 9 und 10).

Ausgehend von der in Figur 3 abgebildeten Struktur werden wie in Figur 4 dargestellt in jeder zweiten Lücke zwischen den Gates 110 im Bereich der n+ -dotierten Bereiche 140 Gräben 150 ausgebildet, welche orthogonal bzw. im Wesentlichen orthogonal zu der Oxidschicht 120 orientierte Seitenwände aufweisen, an denen im weiteren Verlauf des Herstellungsverfahrens Dielektrizitätsschichten 170 von Speicherelementen 20 ausgebildet werden. Das Ausbilden der Gräben 150 umfasst beispielsweise ein Aufbringen einer oder mehrerer Hartmaskenschichten (nicht dargestellt), den nachfolgenden Einsatz eines Lithographie- und eines oder mehrerer Ätzverfahren wie dem selektiven reaktiven Ionenätzen sowie ein Entfernen der Hartmaskenschicht(en).

Wie anhand von Figur 4 ersichtlich wird, wird durch einen Graben 150 ein n+ -dotierter Bereich 140 in zwei durch den Graben 150 voneinander getrennte, nebeneinender angeordneten späteren Speicherzellen 1 jeweils zugehörige Teilbereiche 141 aufgeteilt. Die Tiefe eines Grabens 150, welche vorzugsweise in einem Bereich von 100nm bis 200nm liegt, übersteigt dabei eine maximale Tiefe eines n+ -dotierten Bereichs 140 und damit eine maximale Tiefe eines Teilbereichs 141. Unter der maximalen Tiefe wird jeweils die maximale, sich von der Oberfläche des Substrats 100 nach unten erstreckende Ausdehnung der jeweiligen Bereiche 140, 141 verstanden. Die Teilbereiche 141 dienen sowohl als Drainanschlüsse für Auswahltransistoren 10 als auch als Anschlüsse für Speicherelemente 20 von späteren Speicherzellen 1.

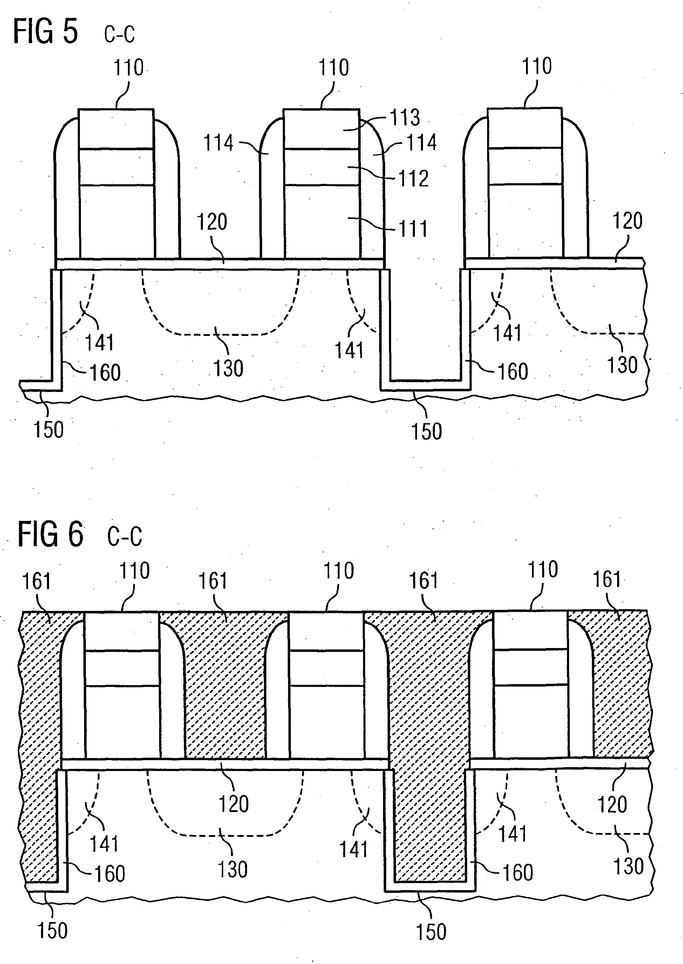

Nachfolgend wird an Seitenwänden und an einem Boden jedes Grabens 150 wie in Figur 5 dargestellt eine Opferoxidschicht 160 ausgebildet. Im Anschluss daran wird jeder Graben 150 als auch entsprechende Bereiche zwischen den Gates 110 mit einem Oxidmaterial 161 gefüllt, wie anhand von Figur 6 ersichtlich wird. Hierzu wird das Oxidmaterial 161 beispielsweise großflächig auf die Oberfläche des Substrats 100 aufgebracht und nachfolgend mithilfe eines CMP-Prozesses (chemischmechanisches Polieren) bis zu einer Oberkante der Gates 110 abgetragen, um die in Figur 6 dargestellte Struktur zu erhalten.

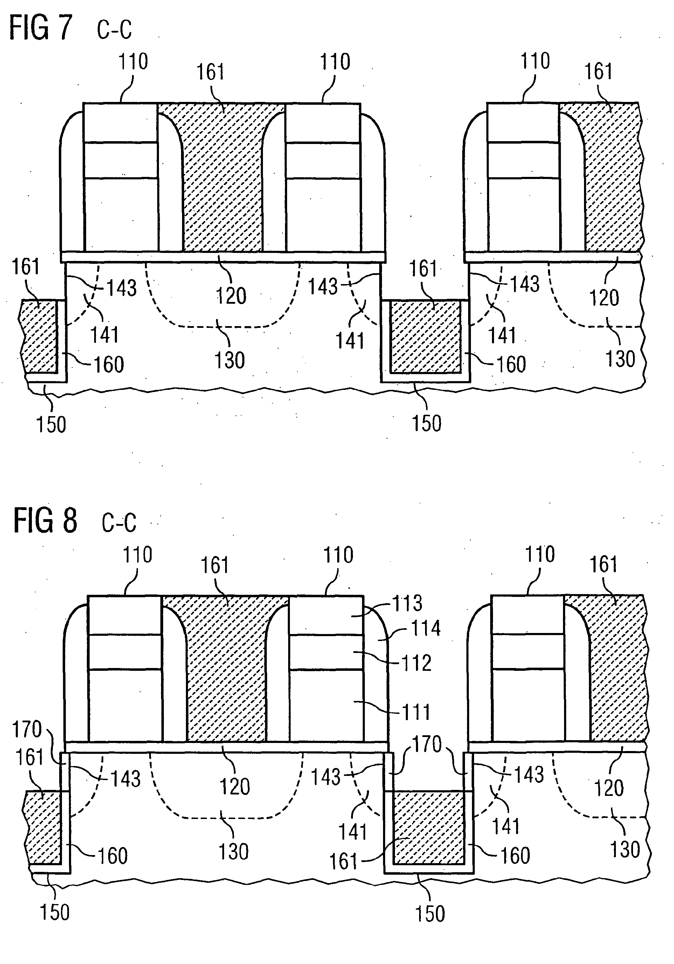

Anschließend wird das Oxidmaterial 161 zwischen den Gates 110 im Bereich der Gräben 150 vollständig sowie das Oxidmaterial 161 als auch das Opferoxid 160 in den Gräben 150 teilweise entfernt, so dass die Gräben 150 wie in Figur 7 dargestellt weiterhin zu einem Teil mit dem Oxid 161 und dem Opferoxid 160 gefüllt sind. Zum Entfernen des Oxidmaterials 161 und des Opferoxids 160 werden entsprechende Lithografie- und Ätzverfahren herangezogen. Das Oxid 161 sowie das zwischen Seitenwänden, einem Boden eines Grabens 150 und dem Oxid 161 angeordnete Opferoxid 160 füllen einen Graben 150 dabei bis zu einem Niveau oberhalb der am Rand des betreffenden Grabens 150 vorliegenden maximalen Tiefe eines Teilbereichs 141.

Auf diese Weise werden durch die zu der Oxidschicht 120 orthogonal verlaufenden Seitenwände eines Grabens 150 vorgegebene freigelegte Anschlussflächen 143 oberhalb des Oxids 161 und des Opferoxids 160 für die Teilbereiche bzw. Anschlüsse 141 bereitgestellt, an denen wie in Figur 8 dargestellt dielektrische Oxidschichten 170 für Speicherelemente 20 von Speicherzellen 1 ausgebildet werden. Die Oxidschichten 170, im folgenden als Dielektrizitätsschichten 170 bezeichnet, werden zur (Wieder-)Programmierung der späteren Speicherzellen 1 genutzt. Da die Dielektrizitätsschichten 170 lediglich oberhalb einer maximalen Tiefenausdehnung der Teilbereiche 141 an den Anschlussflächen 143 ausgebildet werden, wird ein zuverlässiger Betrieb der Speicherzellen 1 ermöglicht. Die Dielektrizitätsschichten 170, welche entsprechend den Seitenwänden der Gräben 150 bzw. den Anschlussflächen 143 der Anschlüsse 141 orthogonal zu der Gateoxidschicht 120 orientiert sind, weisen vorzugsweise eine Dicke in einem Bereich von 2nm bis 3nm auf.

Als abschließenden Verfahrensschritt bei der Herstellung der erfindungsgemäßen Speicherzellen 1 werden, wie in Figur 9 dargestellt, die Dielektrizitätsschichten 170 kontaktierende Anschlüsse 180 und mit den Anschlüssen 180 verbundene Bitleitungen BL auf der Oberfläche des Substrats 100 ausgebildet. Zu diesem Zweck werden vorzugsweise eine undotierte oder eine n+ -dotierte Polysiliziumschicht 181, eine beispielsweise WSi aufweisende Metallschicht 182 und wenigstens eine beispielsweise ein Nitrid aufweisende Hartmaskenschicht 183 großflächig auf das Substrat 100 aufgebracht, wobei die Polysiliziumschicht 181 die freigelegten Zwischenräume zwischen den Gates 110 und die freigelegten Bereiche der Gräben 150 ausfüllt. Nachfolgend wird der Schichtenstapel mithilfe eines Lithographieverfahrens und eines oder mehrerer Ätzverfahren wie beispielsweise dem reaktiven Ionenätzen zur Ausbildung der Bitleitungen BL bzw. Anschlüsse 180 strukturiert.

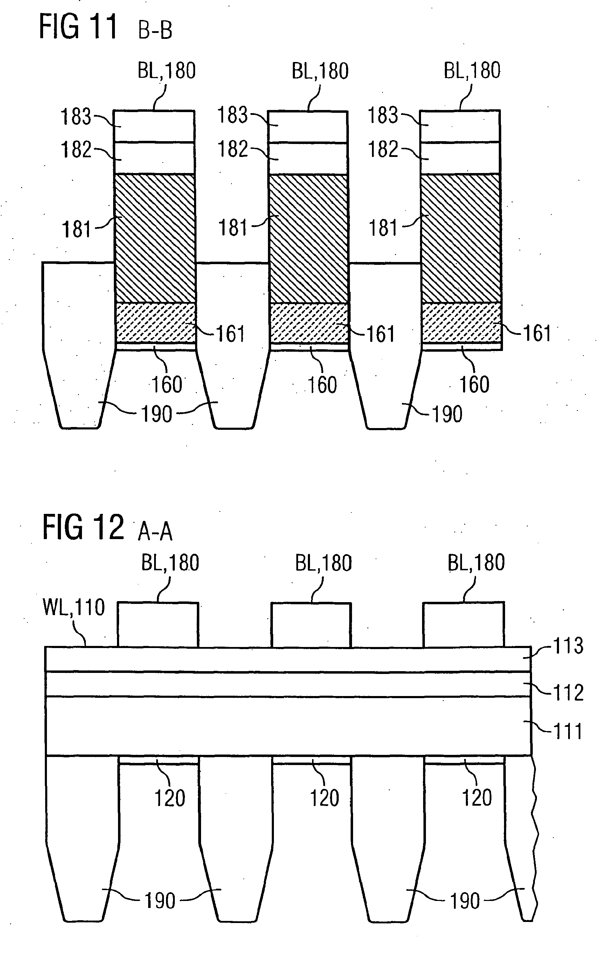

Das auf diese Weise fertig gestellte Speicherzellenfeld mit einer Anzahl von Wortleitungen WL, einer Anzahl von Bitleitungen BL, einer Anzahl von in entsprechenden Schnittpunkten der Wortleitungen WL und Bitleitungen BL angeordneten Speicherzellen 1 sowie einer Anzahl von vergrabenen Sourceleitungen SL ist in der Draufsicht von Figur 10 dargestellt. Figur 9 stellt dabei die seitliche Schnittdarstellung entlang Schnittlinie C-C von Figur 10 dar. Zur besseren Veranschaulichung zeigen die Figuren 11 und 12 weitere Schnittdarstellungen des Speicherzellenfelds entlang Schnittlinie B-B (Figur 11) sowie entlang Schnittlinie A-A (Figur 12) von Figur 10.

Anhand der seitlichen Schnittdarstellung von Figur 9 wird der Aufbau einer einzelnen Speicherzelle 1 ersichtlich. Die Speicherzelle 1 weist einen Auswahltransistor 10 (vorliegend als NMOS-Transistor ausgeführt) mit einer Gateoxidschicht 120, ein mit einer Wortleitung WL verbundenes bzw. durch die Wortleitung WL gebildetes Gate 110 auf der Gateoxidschicht 120, einen als Source dienenden n+ -dotierten Bereich 130 sowie einen als Drain dienenden Anschluss 141 unterhalb der Gateoxidschicht 120 in einem Bereich unterhalb des Gates 110 auf. Der Bereich 130 bildet gleichzeitig eine zwischen Isolationsstreifen 190 verlaufende vergrabene Source-Leitung SL bzw. ist mit einer Sourceleitung SL verbunden (vgl. Figur 10).

Die Speicherzelle 1 weist weiter ein in Serie zu dem Auswahltransistor 10 geschaltetes Speicherelement 20 mit dem Anschluss 141, einer rechtwinklig zu dem Gateoxid 120 des Auswahltransistors 10 orientierten wiederprogrammierbaren Dielektrizitätsschicht 170 sowie einen mit einer Bitleitung BL verbunden Anschluss 180 auf. Der Anschluss 141 wird dabei als gemeinsamer Anschluss sowohl von dem Auswahltransistor 10 als auch von dem Speicherelement 20 der Speicherzelle 1 genutzt.

Aufgrund der orthogonalen Ausrichtung zwischen der Dielektrizitätsschicht 170 des Speicherelements 20 und der Gateoxidschicht 120 des Auswahltransistors 10 können der Auswahltransistor 10 und das Speicherelement 20 in einem relativ kleinen Abstand zueinander angeordnet werden. Auf diese Weise weist die auf dem Substrat 100 ausgebildete erfindungsgemäße Speicherzelle 1 eine geringe laterale Ausdehnung auf der Oberfläche des Substrats 100 auf. Beispielsweise ist es möglich, die Speicherzelle 1 mit einer lateralen Dimension in einem Bereich unterhalb von 50nm zu verwirklichen. Ein Speicher bzw.

Speicherbaustein mit einem die erfindungsgemäßen Speicherzellen 1 umfassenden Speicherzellenfeld zeichnet sich folglich durch eine hohe Integrationsdichte aus. Der geringe Platzbedarf der Speicherzelle 1 wird zudem durch den von dem Auswahltransistor 10 und dem Speicherelement 20 genutzten gemeinsamen Anschluss 141 begünstigt.

Eine platzsparende Geometrie der in dem Speicherzellenfeld angeordneten Speicherzellen 1 wird des Weiteren dadurch erzielt, dass jeweils zwei nebeneinander angeordnete sowie einer Bitleitung BL zugeordnete Speicherzellen 1 einen gemeinsamen Anschluss 180 aufweisen. In entsprechender Weise wird eine geringe laterale Ausdehnung auch dadurch erzielt, dass jeweils zwei nebeneinander angeordnete und einer Bitleitung BL zugeordnete Speicherzellen 1 einen gemeinsamen n+ - dotierten Bereich bzw. Sourceanschluss 130 aufweisen.

Zum Programmieren einer erfindungsgemäßen Speicherzelle 1 wird ein dielektrischer Durchbruch der Dielektrizitätsschicht 170 des Speicherelements 20 der Speicherzelle 1 hervorgerufen. Auf diese Weise verhält sich die Dielektrizitätsschicht 170 nicht mehr wie ein Isolator, sondern wie ein endlicher elektrischer Widerstand. Die Stärke des dielektrischen Durchbruchs gibt dabei das Niveau eines Leckstroms durch die Speicherzelle 1 vor, welches bei einem Lesevorgang der Speicherzelle gemessen wird. Zum Ausbilden eines Durchbruchs der Dielektrizitätsschicht 170 ist es erforderlich, eine ausreichende Potentialdifferenz über dem Speicherelement 20 bzw. über dessen Dielektrizitätsschicht 170 mithilfe der beiden Anschlüsse 141, 180 des Speicherelements 20 einzustellen.

Zu diesem Zweck wird im Falle des als NMOS-Transistor ausgebildeten Auswahltransistors 10 beispielsweise an dem Gate 110 des Auswahltransistors 10 über die entsprechende Wortleitung WL eine von 0 verschiedene positive Spannung sowie an dem Sourceanschluss 130 des Auswahltransistors 10 über die entsprechende Sourceleitung SL eine Spannung von 0V angelegt, um den Auswahltransistor 10 durchzuschalten. Auf diese Weise wird der Drainanschluss 141 des Auswahltransistors 10 ebenfalls auf ein Potential von 0V gebracht. Die angegebenen Potentiale beziehen sich dabei auf das Substrat 100 als Massepotential.

Durch Anlegen eines ausreichend hohen, gegenüber dem an dem Gate 110 des Auswahltransistors 10 angelegten Potential höheren positiven Potentials an dem Anschluss 180 des Speicherelements 20 über die entsprechende Bitleitung BL kann der Durchbruch der Dielektrizitätsschicht 170 zur Programmierung der Speicherzelle 1 erzeugt werden. Der hierdurch hervorgerufene leitende Pfad weist hierbei einen ausreichenden elektrischen Widerstand auf, wodurch ein die Speicherzelle 1 beschädigendes Degradieren bzw. Durchbrechen der Gateoxidschicht 120 des Auswahltransistors 10 unterdrückt wird. Ein Beschädigen der Gateoxidschicht 120 des Auswahltransistors 10 wird weiterhin dadurch vermieden, dass die Dicke der Gateoxidschicht 120 des Auswahltransistors 10 die Dicke der Dielektrizitätsschicht 170 des Speicherelements 20 übersteigt.

Zum Lesen der Speicherzelle 1 wird im Falle des als NMOS-Transistor ausgeführten Auswahltransistors 10 wiederum beispielsweise ein von 0 verschiedenes positives Potential an dem Gate 110 des Auswahltransistors 10 über die entsprechende Wortleitung WL und ein Potential von 0V an dem Sourceanschluss 130 des Auswahltransistors 10 über die entsprechende Sourceleitung SL angelegt. Auf diese Weise wird der Auswahltransistor 10 durchgeschaltet und der Drainanschluss 141 ebenfalls auf ein Potential von 0V gebracht. Des Weiteren wird ein gegenüber dem an dem Gate 110 des Auswahltransistors 10 angelegten Potential niedrigeres positives Potential an dem Anschluss 180 des Speicherelements 20 über die entsprechende Bitleitung BL angelegt. Sofern die Speicherzelle 1 programmiert ist, d.h. die Dielektrizitätsschicht 170 des Speicherelements 20 durchbrochen ist, fließt ein Leckstrom durch die Speicherzelle 1, welcher an der Bitleitung BL mithilfe einer entsprechenden Messvorrichtung gemessen werden kann. Sofern die Speicherzelle 1 nicht programmiert ist, fließt kein bzw. lediglich ein vernachlässigbarer Leckstrom.

Beim Auslesen des Speicherinhalts eines Speicherzellen 1 umfassenden Speicherzellenfelds wird ein Grenzwert für das an den Speicherzellen 1 jeweils ermittelte Leckstromniveau festgelegt. Auf diese Weise können die in den Speicherzellen 1 gespeicherten logischen Zustände (kein bzw. vernachlässigbarer Leckstrom unterhalb des Grenzwerts / Leckstrom oberhalb des Grenzwerts) voneinander unterschieden werden.

Zum Zweck der Wiederprogrammierung einer Speicherzelle 1 kann der vorstehend beschriebene Programmierschritt mehrfach wiederholt werden, wobei hierbei durch Herstellen einer jeweils höheren Potentialdifferenz über der Dielektrizitätsschicht 170 des Speicherelements 20 und/oder Erzeugen der Potentialdifferenz über der Dielektrizitätsschicht 170 für eine jeweils längere Zeitdauer der Grad des dielektrischen Durchbruchs der Dielektrizitätsschicht 170 schrittweise erhöht und damit deren Widerstand schrittweise erniedrigt wird. In entsprechender Weise wird dadurch das Leckstromniveau der Speicherzelle 1 schrittweise angehoben.

Zum "Löschen" des Speicherinhalts eines bereits programmierten Speicherzelle wird der für das Lesen festgesetzte Grenzwert des Leckstromniveaus erhöht. Auf diese Weise kann eine (wieder)programmierte Speicherzelle 1 mit einem erhöhten Leckstromniveau wieder in einen "unprogrammierten" Zustand versetzt werden. Nach jedem erneuten Programmieren von Speicherzellen 1 wird daher in der Regel der Grenzwert für das an den Speicherzellen 1 gemessene Leckstromniveau erhöht, um die in den Speicherzellen 1 gespeicherten logischen Zustände (Leckstromniveau unterhalb des Grenzwerts / Leckstromniveau oberhalb des Grenzwerts) wiederum unterscheiden zu können.

Das anhand der Figuren erläuterte Verfahren sowie die in den Figuren dargestellte Speicherzelle 1 stellen eine bevorzugte Ausführungsform der Erfindung dar. Darüber hinaus sind alternative Ausführungsformen vorstellbar, welche Abwandlungen bzw. Variationen des gezeigten Verfahrens und der abgebildeten Speicherzelle 1 darstellen.

Beispielsweise ist es möglich, ein Gate 110 eines Auswahltransistors 10 als auch einen Anschluss 180 eines Speicherelements 20 einer Speicherzelle 1 mit einem anderen Aufbau als dem dargestellten Schichtenaufbau sowie mit anderen Materialien zu realisieren. Des weiteren ist die Möglichkeit gegeben, anstelle eines für einen Auswahltransistor 10 und ein Speicherelement 20 vorgesehenen gemeinsamen Anschlusses 141 zwei voneinander getrennte, elektrisch miteinander verbundene Anschlüsse auszubilden.

Ferner besteht die Möglichkeit, anstelle von n+ -dotierten Anschlussbereichen 130, 140 bzw. Anschlüssen 141 in einem sich von der Oberfläche erstreckenden p-dotierten Bereich 101 eines Substrats 100 in entsprechender Weise p+ -dotierte Anschlussbereiche in einem sich von der Oberfläche erstreckenden n-dotierten Bereich eines Substrats und damit als PMOS-Transistoren ausgeführte Auswahltransistoren auszubilden.

Auch ist die oben angegebene Verfahrensweise zur (Wieder-) Programmierung und zum Auslesen von Speicherzellen 1 lediglich beispielhafter Natur. Insbesondere beruht das Programmieren bzw. (Wieder-)Programmieren einer Speicherzelle 1 ausschließlich auf dem Hervorrufen bzw. Verstärken eines Durchbruchs der Dielektrizitätsschicht 170 des betreffenden Speicherelements 20 zum Festlegen eines Leckstromniveaus der betreffenden Speicherzelle 1, was durch das Herstellen einer ausreichenden Potentialdifferenz über der Dielektrizitätsschicht 170 nach einem Durchschalten des entsprechenden Auswahltransistors 10 erzielt werden kann.

### Bezugszeichenliste

- 1: Speicherzelle
- 10: Auswahltransistor
- 20: Speicherelement
- 100: Substrat
- 101: p-dotierter Bereich
- 110: Gate
- 111: Polysiliziumschicht
- 112: Metallschicht
- 113: Hartmaskenschicht
- 114: Spacer
- 120: Oxidschicht / Gateoxidschicht
- 130: n+ -dotierter Bereich / Sourceanschluss
- 140: n+ -dotierter Bereich
- 141: Teilbereich / (Drain-)Anschluss
- 143: Anschlussfläche
- 150: Graben
- 160: Opferoxid
- 161: Oxid / Oxidmaterial
- 170: Oxidschicht / Dielektrizitätsschicht
- 180: Anschluss
- 181: Polysiliziumschicht
- 182: Metallschicht
- 183: Hartmaskenschicht
- 190: Isolationsstreifen
- BL: Bitleitung
- SL: Sourceleitung
- WL: Wortleitung

## Patentansprüche

1. Wiederprogrammierbare nichtflüchtige Speicherzelle, aufweisend:
a) einen Auswahltransistor (10) mit
- einer Isolationsschicht (120),
- einem ersten Anschluss (110) auf der Isolationsschicht (120),
- einem zweiten Anschluss (130) unterhalb der Isolationsschicht (120) und in einem Bereich unterhalb des ersten Anschlusses (110),
- einem von dem zweiten Anschluss (130) getrennten dritten Anschluss (141) unterhalb der Isolationsschicht (120) und in einem Bereich unterhalb des ersten Anschlusses (110),
b) ein Speicherelement (20) mit
- einem vierten Anschluss (141),
- einem fünften Anschluss (180),
- einer wiederprogrammierbaren Dielektrizitätsschicht (170),
wobei der vierte Anschluss (141) und der fünfte Anschluss (180) des Speicherelements (20) durch die wiederprogrammierbare Dielektrizitätsschicht (170) voneinander getrennt sind,
wobei der dritte Anschluss (141) des Auswahltransistors (10) mit dem vierten Anschluss (141) des Speicherelements (20) verbunden ist,
**dadurch gekennzeichnet, dass**
die wiederprogrammierbare Dielektrizitätsschicht (170) des Speicherelements (20) im Wesentlichen orthogonal zu der Isolationsschicht (120) des Auswahltransistors (10) angeordnet ist.

2. Speicherzelle nach Anspruch 1, **dadurch gekennzeichnet, dass** der dritte Anschluss (141) des Auswahltransistors (10) und der vierte Anschluss (141) des Speicherelements (20) als gemeinsamer Anschluss (141) ausgebildet sind.

3. Speicherzelle nach einem der vorhergehenden Ansprüche, **dadurch gekennzeichnet, dass** der vierte Anschluss (141) des Speicherelements (20) eine zu der Isolationsschicht (120) des Auswahltransistors (10) im Wesentlichen orthogonal verlaufende Anschlussfläche (143) aufweist, an welcher die wiederprogrammierbare Dielektrizitätsschicht (170) des Speicherelements (20) ausgebildet ist.

4. Speicherzelle nach Anspruch 3, **dadurch gekennzeichnet, dass** die Anschlussfläche (143) des vierten Anschlusses (141) des Speicherelements (20) durch eine zu der Isolationsschicht (120) des Auswahltransistors (10) im Wesentlichen orthogonal verlaufende Seitenwand eines Grabens (150) vorgegeben wird.

5. Speicherzelle nach Anspruch 4, **dadurch gekennzeichnet, dass** eine Tiefe des Grabens (150) eine maximale Tiefe des vierten Anschlusses (141) übersteigt.

6. Speicherzelle nach Anspruch 5, **dadurch gekennzeichnet, dass** der Graben (150) bis zu einem Niveau oberhalb der maximalen Tiefe des vierten Anschlusses (141) mit einer Oxidschicht (161) gefüllt ist, wobei die wiederprogrammierbare Dielektrizitätsschicht (170) des Speicherelements (20) oberhalb der Oxidschicht (161) angeordnet ist.

7. Speicherzelle nach Anspruch 6, **gekennzeichnet durch** eine den Graben (150) bis zu dem Niveau füllende, zwischen Seitenwänden, einem Boden des Grabens (150) und der Oxidschicht (161) angeordnete Zwischenoxidschicht (160).

8. Speicherzelle nach einem der Ansprüche 4 bis 7, **dadurch gekennzeichnet, dass** der Graben (150) eine Tiefe in einem Bereich von 100nm bis 200nm aufweist.

9. Speicherzelle nach einem der vorhergehenden Ansprüche, **dadurch gekennzeichnet, dass** die wiederprogrammierbare Dielektrizitätsschicht (170) des Speicherelements (20) eine Dicke in einem Bereich von 2nm bis 3nm aufweist.

10. Speicherzelle nach einem der vorhergehenden Ansprüche, **dadurch gekennzeichnet, dass** die wiederprogrammierbare Dielektrizitätsschicht (170) des Speicherelements (20) als Oxidschicht ausgebildet ist.

11. Verfahren zum Herstellen einer wiederprogrammierbaren nichtflüchtigen Speicherzelle (1), umfassend die Verfahrensschritte:
a) Bereitstellen eines Substrats (100),
b) Ausbilden einer Ausgangsstruktur, aufweisend:
- eine Isolationsschicht (120) an einer Oberfläche des Substrats (100),
- einen ersten Anschluss (110) auf der Isolationsschicht (120),
- einen zweiten Anschluss (130) unterhalb der Isolationsschicht (120) und in einem Bereich unterhalb des ersten Anschlusses (110),
- einen von dem zweiten Anschluss (130) getrennten dritten Anschluss (140, 141) unterhalb der Isolationsschicht (120) und in einem Bereich unterhalb des ersten Anschlusses (110),
- einen von dem zweiten Anschluss (130) getrennten Anschlussbereich (140) für einen vierten Anschluss (141) in einem Bereich unterhalb des ersten Anschlusses (110),
wobei der Anschlussbereich (140) für den vierten Anschluss (141) mit dem dritten Anschluss (140, 141) verbunden ist,
c) Ausbilden einer zu der Isolationsschicht (120) im Wesentlichen orthogonal verlaufenden Anschlussfläche (143) an dem Anschlussbereich (140), um den vierten Anschluss (141) bereitzustellen,
d) Ausbilden einer Dielektrizitätsschicht (170) an der zu der Isolationsschicht (120) im Wesentlichen orthogonal verlaufenden Anschlussfläche (143) des vierten Anschlusses (141),
e) Ausbilden eines durch die Dielektrizitätsschicht (170) von dem vierten Anschluss (141) getrennten fünften Anschlusses (180) an der Dielektrizitätsschicht (170).

12. Verfahren nach Anspruch 11, wobei das Ausbilden der Ausgangsstruktur die Verfahrensschritte umfasst:
- Ausbilden einer Isolationsschicht (120) an einer Oberfläche des Substrats (100),
- Ausbilden eines ersten Anschlusses (110) auf der Isolationsschicht (120),
- Ausbilden eines zweiten Anschlusses (130), eines von dem zweiten Anschluss (130) getrennten dritten Anschlusses (140, 141) und eines von dem zweiten Anschluss (130) getrennten Anschlussbereichs (140) für den vierten Anschluss (141) unterhalb der Isolationsschicht (120) und in einem Bereich unterhalb des ersten Anschlusses (110).

13. Verfahren nach einem der Ansprüche 11 oder 12, wobei das Ausbilden der Anschlussfläche (143) für den vierten Anschluss (141) ein Ausbilden eines Grabens (150) in dem Substrat (100) im Bereich des Anschlussbereichs (140) mit einer zu der Isolationsschicht (120) im Wesentlichen orthogonal verlaufenden Seitenwand (143) umfasst.

14. Verfahren nach Anspruch 13, wobei eine Tiefe des Grabens (150) eine maximale Tiefe des Anschlussbereichs (140) übersteigt.

15. Verfahren nach einem der Ansprüche 13 oder 14, umfassend die Verfahrensschritte nach dem Ausbilden des Grabens (150):
- Ausbilden einer Oxidschicht (161) in dem Graben (150), wobei die Oxidschicht (161) den Graben (150) bis zu einem Niveau oberhalb einer maximalen Tiefe des vierten Anschlusses (141) füllt,
- Ausbilden der Dielektrizitätsschicht (170) oberhalb der Oxidschicht (161) an der zu der Isolationsschicht (120) im Wesentlichen orthogonal verlaufenden Anschlussfläche (143) des vierten Anschlusses (141).

16. Verfahren nach Anspruch 15, wobei das Ausbilden der Oxidschicht (161) in dem Graben die Verfahrensschritte umfasst:
- Ausbilden einer Zwischenoxidschicht (160) an Seitenwänden und an einem Boden des Grabens (150),
- Füllen des Grabens (150) mit einem Oxidmaterial (161) für die Oxidschicht,
- Entfernen des Oxidmaterials (161) und der Zwischenoxidschicht (160) bis zu dem Niveau oberhalb der maximalen Tiefe des vierten Anschlusses (141), um die Oxidschicht (161) in dem Graben (150) auszubilden.

17. Verfahren nach einem der Ansprüche 11 bis 16, wobei der dritte Anschluss (141) und der vierte Anschluss (141) als gemeinsamer Anschluss (141) ausgebildet werden.

18. Verfahren nach einem der Ansprüche 11 bis 17, wobei die Dielektrizitätsschicht (170) als Oxidschicht an der zu der Isolationsschicht (120) im Wesentlichen orthogonal verlaufenden Anschlussfläche (143) des vierten Anschlusses (141) ausgebildet wird.

19. Verfahren nach einem der Ansprüche 11 bis 18, wobei der zweite, dritte und vierte Anschluss (130, 141) bzw. der Anschlussbereich (140) für den vierten Anschluss (140) durch Dotieren des Substrats (100) ausgebildet werden.

20. Speicherzellenfeld, mit einer Anzahl von Wortleitungen (WL), einer Anzahl von Bitleitungen (BL) und einer Anzahl von in entsprechenden Schnittpunkten der Wortleitungen (WL) und Bitleitungen (BL) angeordneten wiederprogrammierbaren nichtflüchtigen Speicherzellen (1) nach einem der Ansprüche 1 bis 10,
wobei eine Wortleitung (WL) mit einem ersten Anschluss (110) eines Auswahltransistors (10) einer Speicherzelle (1) und eine Bitleitung (BL) mit einem fünften Anschluss (180) eines Speicherelements (20) einer Speicherzelle (1) verbunden ist.

21. Speicherzellenfeld nach Anspruch 20, wobei jeweils zwei nebeneinander angeordnete Speicherzellen (1) einen gemeinsamen fünften Anschluss (180) aufweisen.

22. Speicherzellenfeld nach einem der Ansprüche 20 oder 21, wobei jeweils zwei nebeneinander angeordnete Speicherzellen (1) einen gemeinsamen zweiten Anschluss (130) aufweisen.

23. Speicherzellenfeld nach einem der Ansprüche 20 bis 22, mit einer Anzahl von Sourceleitungen (SL), wobei eine Sourceleitung (SL) mit einem zweiten Anschluss (130) eines Auswahltransistors (10) einer Speicherzelle (1) verbunden ist.
